(19) Europäisches Patentamt
European Patent Office
Office européen des brevets

(11) EP 4 778 969 A1

(12) EUROPEAN PATENT APPLICATION
published in accordance with Art. 153(4) EPC

(43) Date of publication:
**22.07.2026 Bulletin 2026/30**

(21) Application number: **24865747.0**

(22) Date of filing: **03.09.2024**

(51) International Patent Classification (IPC):
***C08K 5/5435*** (2006.01) ***C08L 63/00*** (2006.01)
***H01L 23/29*** (2006.01)

(52) Cooperative Patent Classification (CPC):
**C08K 5/5435; C08L 63/00; H10W 74/40**

(86) International application number:
**PCT/KR2024/013209**

(87) International publication number:
**WO 2025/058306 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **11.09.2023 KR 20230120635**

(71) Applicant: **Momentive Performance Materials Inc.**
**Niskayuna, NY 12309 (US)**

(72) Inventors:
- **LEE, Eun Han**
  **Yongin-si, Gyeonggi-do 16917 (KR)**
- **SHIM, Myoung Taek**
  **Gwangju 66246 (KR)**
- **KIM, Seung Taek**
  **Yongin-si, Gyeonggi-do 16998 (KR)**
- **KONG, Byung Seon**
  **Yongin-si, Gyeonggi-do 17013 (KR)**
- **IJIMA, Yoichiro**
  **Fujisawa City, Kanagawa 251-0021 (JP)**
- **MOCHIZUKI, Kyohei**
  **Yokohama City, Kanagawa 222--0011 (JP)**
- **SASAKI, Motoshi**
  **Ohta City, Gunma 3700841 (JP)**
- **SIVASUBRAMANIAN, Karthikeyan**
  **Bangalore 560102 (IN)**
- **KAUR, Banpreet**
  **14197 Berlin (DE)**
- **PHUKAN, Monjit**
  **New York 10604 (US)**

(74) Representative: **Pfenning, Meinig & Partner mbB**
**Patent- und Rechtsanwälte**
**Theresienhöhe 11a**
**80339 München (DE)**

# (54) EPOXY RESIN COMPOSITION FOR MOLDING

(57) The present invention relates to an epoxy resin composition for molding and a semiconductor device molded by using the same.

EP 4 778 969 A1

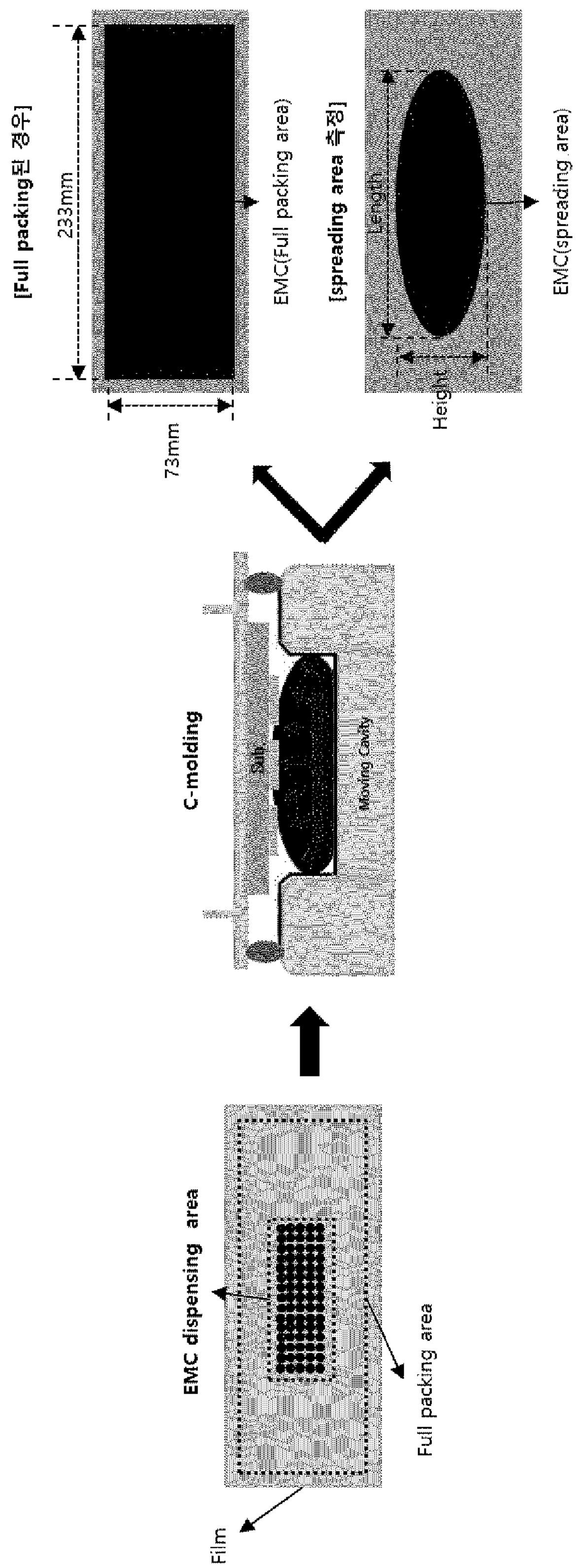
[Full packing된 경우]
233mm
73mm
EMC(Full packing area)
[spreading area 측정]
Length
Height
EMC(spreading area)
C-molding
EMC dispensing area
Full packing area
Film

FIG. 1

## Description

[Technical Field]

The present invention relates to an epoxy resin composition for molding and a semiconductor device molded by using the same.

[Background Art]

A resin composition for encapsulation is used as a material that improves the properties and reliability of semiconductor devices by sealing semiconductor elements such as integrated circuits (ICs), large-capacity integrated circuits (LSIs), transistors, and diodes. Recently, as high integration of semiconductors is accelerated in accordance with trends in miniaturization, weight reduction, and high performance of electronic devices, research to improve the performance of materials used for sealing semiconductor devices is continuing in various fields. For example, Japanese Patent Publication No. 2017-197620 relates to an epoxy resin composition for semiconductor encapsulation, comprising an epoxy resin, a phenol resin curing agent and a filler, and discloses a technique for increasing electrical connection reliability by adjusting the content of a filler and the thermal elasticity of a cured product of an epoxy resin composition.

In particular, when applied to a multi-layered semiconductor package, it is important to fill small gaps, and thus, excellent meltability is required for the epoxy resin composition. However, in the case of a conventional epoxy resin composition having increased meltability, there is a problem of the occurrence of a swelling phenomenon in which an epoxy molding compound (EMC) leaks out of a mold cavity during compression molding under high pressure in a vacuum environment.

Accordingly, there is a need to develop an epoxy resin composition for molding, which has excellent meltability and an improved gap-filling property, while having an excellent swelling inhibition property.

[Detailed Description of Invention]

[Technical Problem]

The present invention provides an epoxy resin composition for molding having excellent meltability and a swelling inhibition property, and a semiconductor device molded by using the same.

[Technical Solution]

The present invention provides an epoxy resin composition comprising an epoxy resin, a curing agent, a filler, and organopolysiloxane, wherein the organopolysiloxane is a linear organosiloxane of a symmetrical structure having an epoxy group at both ends.

[Advantageous Effects]

The present invention provides an epoxy resin composition for molding, which has excellent meltability, and thus an improved gap filling property and an excellent swelling inhibition property are exhibited. The epoxy resin composition according to the present invention can be applied to a compression molding method, and in particular, can be applied as a granular epoxy molding compound (EMC) owing to the excellent swelling inhibition property.

[Brief Description of Drawings]

FIG. 1 is a schematic diagram showing a method for evaluating the meltability of an epoxy resin composition.
FIG. 2 is a schematic diagram showing a method for evaluating the swelling property of an epoxy resin composition.

[Best Mode]

Hereinafter, the present invention will be described in detail. However, the present invention is not limited only by the following contents, and each component may be variously modified or optionally mixed as needed. Therefore, it should be understood to include all modifications, equivalents, and substitutes included in the spirit and scope of the present invention.

The "softening point" used herein is measured by a conventional method known in the art, and can be measured, for example, with a dropping point system calorimetry DP70 from Mettler Toledo. The "viscosity" is measured by a conventional method known in the art, and can be measured by using, for example, a Brookfield viscometer, at room temperature (25 °C). The "particle size (D50)" is measured by a conventional method known in the art, and can be measured, for example, by a laser particle size analyzer.

<Epoxy Resin Composition>

The epoxy resin composition according to the present invention includes an epoxy resin, a curing agent, a filler, and organopolysiloxane. The present invention provides an epoxy resin composition for sealing, which has excellent meltability and an improved gap-filling property and an excellent swelling inhibition property, by using linear organosiloxane of a symmetrical structure having an epoxy group at both ends.

The epoxy resin composition of the present invention can be manufactured in liquid form, powder form, granule form, or sheet form, and can be used as a sealing material (epoxy molding compound (EMC)) for semiconductor devices or a molding material or fixing material for various electronic parts and automotive parts. In one example, the epoxy resin composition for molding, of the present invention, can be applied for sealing of large-area semiconductor packages that are large in size and thin in thickness, and may be made of granular EMC that can be applied to a compression-type molding process, a C-molding process, or a lamination process.

<u>Epoxy Resin</u>

The epoxy resin composition of the present invention includes an epoxy resin. The epoxy resin is used as a main resin and reacts with a curing agent to form a three-dimensional network structure after curing, thereby imparting strong and firm adhesive properties and heat resistance to an object to be adhered.

As the epoxy resin, epoxy resin commonly used in the art may be used. Non-limiting examples of a usable epoxy resin include a bisphenol A type epoxy resin, alicyclic type epoxy resin, cresol novolac type epoxy resin, bisphenol F type epoxy resin, bisphenol S type epoxy resin, naphthalene type epoxy resin, anthracene type epoxy resin, tetramethyl biphenyl type epoxy resin, phenol novolac type epoxy resin, bisphenol A novolac type epoxy resin, bisphenol S novolac type epoxy resin, biphenyl novolac type epoxy resin, naphthol novolac type epoxy resin, naphthol phenol coaxial novolac type epoxy resin, naphthol cresol coaxial novolac type epoxy resin, aromatic hydrocarbon form aldehyde resin modified phenol resin type epoxy resin, triphenyl methane type epoxy resin, tetraphenyl ethane type epoxy resin, dicyclopentadiene type epoxy resin, dicyclopentadiene phenol addition reaction type epoxy resin, biphenyl type epoxy resin, phenol aralkyl type epoxy resin, polyfunctional phenolic resin, naphthol aralkyl type epoxy resin, etc., and may include at least one of these epoxy resins.

In one example, the epoxy resin may include formaldehyde, polymer with 1,1'-biphenyl and phenol, glycidyl ether; 4,4-bis(2,3-epoxypropoxy)-3,3,5,5-tetramethyl (1,1-biphenyl); or mixtures thereof.

In one example, the epoxy resin may include formaldehyde, polymer with 1,1'-biphenyl and phenol, glycidyl ether; and 4,4-bis(2,3-epoxypropoxy)-3,3,5,5-tetramethyl(1,1-biphenyl). In this case, while maintaining mechanical strength properties such as flexural strength of the epoxy resin composition, viscosity and flowability properties may be further improved.

As the epoxy resin, one having an epoxy equivalent weight (EEW) of 100-500 g/eq, for example, 150-300 g/eq, may be used. When the EEW is less than the range stated above, the curing density may be high and moisture resistance may be deteriorated, and when the EEW exceeds the range stated above, the curability may be deteriorated.

As the epoxy resin, one having a softening point of 30-150 °C, for example, 50-110 °C, may be used. When the softening point is less than the range stated above, caking properties may be deteriorated, and when the softening point exceeds the range stated above, non-uniform dispersion may occur during manufacturing.

On the basis of the total weight of the epoxy resin composition, the content of the epoxy resin may be 2-20% by weight, for example, 5-15% by weight. When the content of the epoxy resin is less than the range stated above, adhesiveness, flowability, and formability may be deteriorated, and when the content of the epoxy resin exceeds the range stated above, the reliability of the semiconductor may be deteriorated due to an increase in moisture absorption, and the strength may be lowered due to a relative decrease in the content of fillers.

<u>Curing Agent</u>

The epoxy resin composition of the present invention includes a curing agent. The curing agent reacts with the epoxy resin to promote curing of the composition.

As the curing agent, a curing agent known in the art to undergo a curing reaction with epoxy resin may be used, and the curing agent may be a phenolic compound having two or more phenolic hydroxyl groups in one molecule. Non-limiting examples of a usable curing agent may include phenol novolac resin, cresol novolac resin, phenol aralkyl resin, polyfunctional phenol compound, etc., and may include one or more of these curing agents.

In one example, the curing agent may include phenol polymer with 4,4-bis(methoxymethyl)1,1-bisphenyl, phenol polymer with formaldehyde, or mixtures thereof.

In one example, the curing agent may include phenol polymer with 4,4-bis(methoxymethyl)1,1-bisphenyl and phenol polymer with formaldehyde. In this case, viscosity and meltability properties of the epoxy resin composition may be further improved while maintaining mechanical strength, such as flexural strength.

As the curing agent, one having a hydroxyl equivalent of 90-300 g/eq, for example, 100-200 g/eq, may be used. When the hydroxyl equivalent is less than the range stated above, the reliability in moisture resistance may be deteriorated, and when the hydroxyl equivalent exceeds the range stated above, the curability may be deteriorated.

As the curing agent, one having a softening point of 50-120 °C, for example, 55-90 °C, may be used. When the softening point is less than the range stated above, the caking property may be inferior, and when the softening point exceeds the range stated above, the flowability may be deteriorated.

On the basis of the total weight of the epoxy resin composition, the content of the curing agent may be 2-20% by weight, for example, 2-10% by weight. When the content of the curing agent is less than the range stated above, the curability and formability may be lowered, and when the content of the curing agent exceeds the range stated above, the reliability of the semiconductor may be deteriorated and the strength may be lowered, due to an increase in moisture absorption.

## Filler

The epoxy resin composition of the present invention includes a filler. The filler serves to improve the mechanical properties (e.g., strength) of the epoxy resin composition and lower the moisture absorption.

As the filler, any inorganic filler that is commonly used in the field of electronic materials may be used without particular limitation. In one example, inorganic fillers, such as silica, silica nitride, alumina, aluminum nitride, and boron nitride, may be used, and these may be used alone or in combination of two or more.

The shape of the filler is not particularly limited, and both angular and spherical shapes can be used. Non-limiting examples of the filler that can be used in the present invention include natural silica, synthetic silica, fused silica, etc., and spherical silica particles may be used.

The filler may include two or more types of fillers having different particle sizes. In this case, formability and workability of the epoxy resin composition can be further improved. In one example, the filler may include a first filler having an average particle diameter (D50) of 3.5-20 μm, for example, 3.5-15 μm, and a second filler having an average particle diameter (D50) of 0.1-3 μm, for example, 0.1-1 μm.

On the basis of the total weight of the epoxy resin composition, the content of the filler may be 50-90% by weight, for example, 70-90% by weight. When the content of the filler is less than the range stated above, the moisture absorption amount of the cured product may increase, which may decrease the reliability of a semiconductor device, and when the content of the filler exceeds the range stated above, the flowability may be lowered, and thus, the formability may be deteriorated.

## Organosiloxane

To improve dispersibility, the epoxy resin composition of the present invention includes organosiloxane. The organopolysiloxane is a linear organosiloxane having a symmetrical structure having an epoxy group at both ends, and can provide an epoxy resin composition for sealing, by using the organopolysiloxane of this structure, which has an excellent swelling inhibition property and at the same time, having an improved gap filling property by having excellent meltability.

By having a symmetrical linear molecular structure, the organosiloxane has high compatibility with an epoxy resin composition, specifically, an epoxy resin composition including a biphenyl-based epoxy resin. In addition, by having a reactive epoxy group at both ends, the organosiloxane can effectively disperse the epoxy resin composition by participating in a cross-linking curing reaction between an epoxy resin and a phenol curing agent, as a reactive diluent. As a result, by lowering the surface tension of a molten epoxy resin composition, swelling of internal bubbles in the cured epoxy resin composition can be inhibited, and the viscosity of the molten epoxy resin composition can be lowered to improve moldability. In addition, the organosiloxane can maintain adhesion of the epoxy resin composition and improve meltability and swelling inhibition properties.

The organosiloxane may be represented by Chemical Formula 1 below:

[Chemical Formula 1]

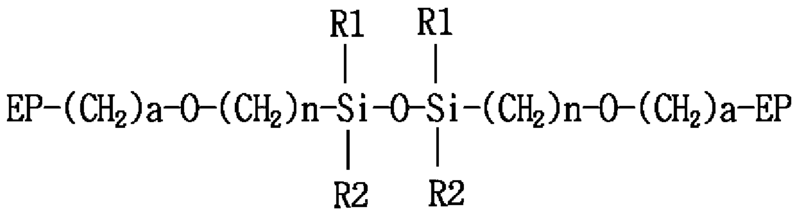

wherein:

EP is an epoxy group;
R1 is hydrogen or a substituted or unsubstituted hydrocarbon group having 1-5 carbon atoms;
R2 is hydrogen or a substituted or unsubstituted hydrocarbon group having 1-5 carbon atoms;
a is an integer from 1 to 5; and
n is an integer from 1 to 5.

In one example, in the above formula, EP is an epoxy group, R1 is hydrogen or a substituted or unsubstituted alkyl group having 1-5 carbon atoms, R2 is hydrogen or a substituted or unsubstituted alkyl group having 1-5 carbon atoms, a is an integer of 1 to 5, and n is an integer of 1 to 5.

In one example, in the above formula, EP is an epoxy group, R1 is a substituted or unsubstituted alkyl group having 1-3 carbon atoms, R2 is a substituted or unsubstituted alkyl group having 1-3 carbon atoms, a is an integer of 1 to 3, and n is an integer of 1 to 3.

In one example, in the above formula, EP is an epoxy group, R1 is a methyl group, R2 is a methyl group, a is 1, and n is 3.

As the organosiloxane, one having a molecular weight of 300-800 g/mol, for example, 300-500 g/mol, and a viscosity (25 °C) of 0.005-1 Pa·s, for example, 0.05-0.1 Pa·s, may be used. When the organosiloxane having the low molecular weight and low viscosity within the ranges stated above is used, it is advantageous for mixing of the epoxy resin composition to exhibit high dispersibility. When the molecular weight or viscosity exceeds the range stated above, the compatibility between the epoxy resin composition and the organosiloxane may be lowered to lower a dispersibility effect, and appearance defects, such as flow marks, may occur.

On the basis of the total weight of the epoxy resin composition, the content of the organosiloxane may be 0.05-5% by weight, for example, 0.1-3% by weight. When the content of the organosiloxane is less than the range stated above, improvement in meltability and a swelling inhibition effect may be limited, and when the content of the organosiloxane exceeds the range stated above, the reliability and strength of the epoxy resin composition may be lowered.

Additives

The epoxy resin composition of the present invention may additionally include additives that are commonly used in the composition. Non-limiting examples of usable additives include a catalyst, a coupling agent, an ion catcher, a coloring agent, a release agent, and the like.

A catalyst promotes a curing reaction, and usable examples thereof may include an imidazole-based compound, a naphthalene-based latent catalyst, an amine-based compound, an organometallic compound, an organophosphorus compound, a boron compound, and the like. A coupling agent promotes the bonding between inorganic and organic materials, and amino silane, epoxy silane, etc. may be used. An ion catcher traps and removes impurity ions to reduce corrosion, and an inorganic ion exchanger, such as magnesium aluminum hydroxide carbonate hydrate, may be used. A coloring agent is added to impart a color to the resin composition, and carbon black, bengala, etc. may be used as the coloring agent. A release agent is added to ensure releasability between a cured epoxy resin compound and a mold, and paraffin wax, carnauba wax, polyethylene wax, ester wax, etc. may be used as the release agent.

The additives may be added within a content range known in the art, and, for example, on the basis of the total weight of the epoxy resin composition, may be included in an amount of 0.01-5% by weight, but is not limited thereto.

The epoxy resin composition according to the present invention can be prepared by a conventional method known in the art, for example, a melt-kneading method using a banbury mixer, a kneader, a roll, a single- or twin-screw extruder, and co-kneader.

The epoxy resin composition of the present invention can be manufactured in powder form, granular form, and the like. In particular, the epoxy resin composition according to the present invention has excellent swelling inhibition properties and can be manufactured in a granular form and applied to a compression molding method.

In one example, a powder-type or granular-type epoxy resin composition can be manufactured by uniformly mixing the above-described components, melting and mixing at a temperature of 80-130 °C by using a heat kneader, cooling to room temperature, and then pulverizing to a powder state, followed by sieving, but not limited thereto.

<Semiconductor Device and Automotive Parts>

The present invention provides a molded semiconductor device using the above-described epoxy resin composition. The semiconductor device may be a transistor, a diode, a microprocessor, a semiconductor memory, or a power semiconductor.

In addition, the present invention provides an automotive part molded by using the above-described epoxy resin composition. In an example, the epoxy resin composition can be used as a molding material to fix and seal components in an automotive part, and, specifically, a permanent magnet may be inserted into an empty space formed in a rotor core of a vehicle motor, and the epoxy resin composition of the present invention may be filled between the empty space and the permanent magnet to fix the permanent magnet in the rotor core.

A method for molding a semiconductor device or molding an automotive part by using the epoxy resin composition of the present invention may be appropriately selected and performed according to a conventional method in the art, for example, transfer molding, compression molding, injection molding, and the like.

[Modes of the Invention]

Hereinafter, the present invention will be described in more detail through examples. However, the following examples are only for a better understanding of the present invention, and the scope of the present invention is not limited to the examples in any sense.

**[Examples 1-4]**

After blending various components according to the compositions shown in Table 1, the blended product was melted and mixed at a temperature of 100-130 °C by using a melt kneader, cooled to room temperature, and pulverized into powder, followed by sieving, thereby preparing the granular epoxy resin composition of each example.

**[Comparative Examples 1-7]**

Except for the compositions shown in Table 2 below, granular epoxy resin compositions of each comparative example were prepared in the same manner as in Examples.

[Table 1]

| Component | Example 1 | Example 2 | Example 3 | Example 4 |
|---|---|---|---|---|
| Epoxy resin 1 | 7.5 | 6.0 | 3.7 | 1.4 |
| Epoxy resin 2 | | 1.5 | 3.7 | 5.6 |
| Curing agent 1 | 1.2 | 1.2 | 1.3 | 1.3 |
| Curing agent 2 | 2.6 | 2.6 | 2.6 | 3.0 |
| Filler | 87.5 | 87.5 | 87.5 | 87.5 |
| Organosiloxane 1 | 0.2 | 0.2 | 0.2 | 0.2 |
| Organosiloxane 2 | | | | |
| Organosiloxane 3 | | | | |
| Organosiloxane 4 | | | | |
| Ion catcher | 0.1 | 0.1 | 0.1 | 0.1 |
| Catalyst | 0.2 | 0.2 | 0.2 | 0.2 |
| Coupling agent | 0.3 | 0.3 | 0.3 | 0.3 |
| Coloring agent | 0.3 | 0.3 | 0.3 | 0.3 |
| Release agent | 0.1 | 0.1 | 0.1 | 0.1 |

(continued)

| Component | Example 1 | Example 2 | Example 3 | Example 4 |
|---|---|---|---|---|
| Total | 100.0 | 100.0 | 100.0 | 100.0 |

[Table 2]

| Component | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|
| Epoxy resin 1 | 7.5 | 6.0 | 3.7 | 1.4 | 7.5 | 7.5 | 7.5 |
| Epoxy resin 2 | | 1.5 | 3.7 | 5.6 | | | |
| Curing agent 1 | 1.3 | 1.3 | 1.4 | 1.4 | 1.2 | 1.2 | 1.2 |
| Curing agent 2 | 2.7 | 2.7 | 2.7 | 3.1 | 2.6 | 2.6 | 2.6 |
| Filler | 87.5 | 87.5 | 87.5 | 87.5 | 87.5 | 87.5 | 87.5 |
| Organosiloxane 1 | | | | | | | |
| Organosiloxane 2 | | | | | 0.2 | | |
| Organosiloxane 3 | | | | | | 0.2 | |
| Organosiloxane 4 | | | | | | | 0.2 |
| Ion catcher | 0.1 | 0.1 | 0.1 | 0.1 | 0.1 | 0.1 | 0.1 |
| Catalyst | 0.2 | 0.2 | 0.2 | 0.2 | 0.2 | 0.2 | 0.2 |
| Coupling agent | 0.3 | 0.3 | 0.3 | 0.3 | 0.3 | 0.3 | 0.3 |
| Coloring agent | 0.3 | 0.3 | 0.3 | 0.3 | 0.3 | 0.3 | 0.3 |
| Release agent | 0.1 | 0.1 | 0.1 | 0.1 | 0.1 | 0.1 | 0.1 |
| Total | 100.0 | 100.0 | 100.0 | 100.0 | 100.0 | 100.0 | 100.0 |

Epoxy resin 1: Multifunctional epoxy resin (Formaldehyde, polymer with 1,1'-biphenyl and phenol, glycidyl ether, Cas no. 1201169-35-8)
Epoxy resin 2: Biphenyl-based epoxy resin (4,4-bis(2,3-epoxypropoxy)-3,3,5,5-tetramethyl(1,1-biphenyl))
Curing agent 1: Multifunctional phenolic resin (Phenol polymer with 4,4-bis(methoxymethyl)1,1-bisphenyl, Cas no. 0106466-55-1)
Curing agent 2: Phenolic novolac resin (Phenol polymer with hydroxybenzaldehyde, Cas no. 0205830-20-2)
Filler: Silicon dioxide
Organosiloxane 1: 1,3-bis(3-(2,3-epoxypropoxy)propyl) 1,1,3,3-tetramethyldisiloxane
Organosiloxane 2: Organosiloxane having an amino group at both ends (Dual-end type/Amino-modified Silicone Fluids, viscosity (25 °C) 25 $mm^2/s$, Mw 1,600 g/mol, amine value 70 mgKOH/g)
Organosiloxane 3: 3-[2-(3,4-epoxycyclohexyl)ethyl]-heptamethyltrisiloxane
Organosiloxane 4: Modified siloxane having an epoxy group and a polyether group at side chains (Epoxy and polyether modified silicone polymer, Cas no. 0101810-98-4, kinematic viscosity (25 °C) of 2,200 $mm^2/s$, epoxy equivalent weight of 5,200 g/mol)
Ion catcher: (Carbonato)hexadecahydroxydialuminum-hexamagnesium
Catalyst: 5-Methyl-2-phenylimidazole-4-methanol
Coupling agent: (3-Mercaptopropyl)trimethoxysilane
Coloring agent: Carbon black
Release agent: Ester wax

**[Property Evaluation]**

The properties of the epoxy resin compositions prepared in Examples and Comparative Examples were measured as follows, and the results are shown in Tables 3 and 4 below.

Spiral flow

After molding the epoxy resin compositions prepared according to Examples and Comparative Examples by using a spiral flow mold in a heat transfer molding machine (pressure: 16 kg/cm$^2$; temperature: 175 °C; curing time: 120 seconds), the flowability of each product was measured.

Gel time

After putting the epoxy resin compositions prepared according to Examples and Comparative Examples in a gel timer and spreading them widely and evenly, the gel time of each product measured.

Flexural strength

The flexural strength was measured according to ASTM D638, D256, and D790.

Flexural modulus

After molding the epoxy resin compositions prepared according to Examples and Comparative Examples by using a sample production mold (125 mm in width, 12.5 mm in length, 6 mm in thickness) in a heat transfer molding machine (pressure: 70 kg/cm$^2$; temperature: 175 °C; curing time: 120 seconds), and then curing in an oven at 175 °C for 4 hours, the flexural modulus was measured according to a universal testing machine (UTM).

Meltability

As shown in FIG. 1, each of the epoxy resin compositions (6.0 g) prepared according to Examples and Comparative Examples was dispensed on a release film with a small area, and, after compression-molding by using compression molding equipment at a temperature of 175 ° C, with a maximum pressure of 30 tons, a compression time of 25 s (time to reach the maximum pressure), and a cure time of 120 s, to melt the epoxy resin compositions, the spreading areas of the melted compositions were measured. A spreading area ratio was calculated according to the following formula to evaluate the meltability of each of the epoxy resin compositions:

$$spreading\ area\ ratio(\%) = \frac{spreading\ area(mm^2)}{full\ packing\ area(mm^2)}.$$

Swelling property

As shown in FIG. 2, 2.0 g of each of the epoxy resin compositions prepared according to Examples and Comparative Examples was weighed into a vial, and the measured vial was left on a hot plate in a vacuum state at 175 ° C and 640 (torr) for 5 minutes. Thereafter, the swelling heights of samples were measured. The change rate was calculated according to the following formula to evaluate swelling properties:

$$Swelling\ height(\%) = \frac{\Delta H(mm)}{H_0(mm)}.$$

$H_o$: Height before heating
$\triangle H$: Height after heating - $H_o$

[Table 3]

| Property | Unit | Example 1 | Example 2 | Example 3 | Example 4 |
|---|---|---|---|---|---|
| Spiral flow | Inch | 65 | 79 | 89 | 97 |
| Gel time | Second | 60 | 69 | 71 | 74 |
| Flexural strength | $Kgf/mm^2$ | 17 | 16 | 15 | 14 |
| Flexural modulus | | 2450 | 2400 | 2300 | 2200 |
| C-mold spreading area ratio | % | 62 | 79 | 88 | 95 |
| Swelling height ratio | | 0 | 0 | 0 | 0 |

[Table 4]

| Property | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|
| Spiral flow | 53 | 68 | 80 | 89 | 60 | 54 | 54 |
| Gel time | 57 | 65 | 66 | 69 | 59 | 58 | 58 |
| Flexural strength | 17 | 16 | 15 | 14 | 16 | 17 | 16 |
| Flexural modulus | 2450 | 2400 | 2300 | 2200 | 2400 | 2450 | 2350 |
| C-mold spreading area ratio | 54 | 72 | 82 | 88 | 60 | 53 | 55 |
| Swelling height ratio | 38 | 55 | 56 | 60 | 53 | 30 | 37 |

As shown in Tables 3 and 4, the epoxy resin compositions of Examples 1-4 including the organosiloxane (organosiloxane 1) according to the present invention having a symmetric linear structure having an epoxy group at both ends showed excellent properties in overall measurement items.

However, the epoxy resin compositions of Comparative Examples 1-4 without using organosiloxane exhibited poor meltability or swelling inhibition properties. In addition, the epoxy resin compositions of Comparative Example 5 in which organosiloxane (organosiloxane 2) having an amino group at both ends, instead of the organosiloxane according to the present invention, is used, Comparative Example 6 in which organosiloxane (organosiloxane 3) having an epoxy group at a side chain, rather than at both ends, is used, and Comparative Example 7 in which organosiloxane (organosiloxane 4) having an epoxy group and a polyether group at side chains, rather than at ends, is used, showed poor meltability or swelling inhibition properties.

[Industrial Applicability]

The present invention provides an epoxy resin composition for molding, which has excellent meltability, and thus an improved gap filling property and an excellent swelling inhibition property are exhibited.

## Claims

**1.** An epoxy resin composition comprising an epoxy resin, a curing agent, a filler, and an organosiloxane, wherein the organosiloxane is a linear organosiloxane of a symmetrical structure having an epoxy group at both ends.

**2.** The epoxy resin composition as claimed in claim 1, wherein the epoxy resin has a softening point of 30-150 °C, and the curing agent has a softening point of 50-120 °C.

**3.** The epoxy resin composition as claimed in claim 1, wherein the organosiloxane is represented by Chemical Formula 1 below:

[Chemical Formula 1]

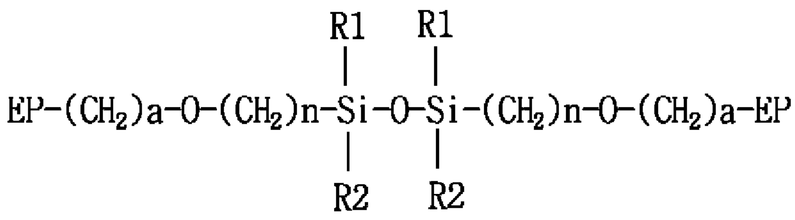

wherein:

EP is an epoxy group;
R1 is hydrogen or a substituted or unsubstituted hydrocarbon group having 1-5 carbon atoms;
R2 is hydrogen or a substituted or unsubstituted hydrocarbon group having 1-5 carbon atoms;
a is an integer from 1 to 5; and
n is an integer from 1 to 5.

**4.** The epoxy resin composition as claimed in claim 1, wherein the organosiloxane has a molecular weight of 300-800 g/mol and a viscosity (25 °C) of 0.005-1 Pa·s.

**5.** The epoxy resin composition as claimed in claim 1, wherein the epoxy resin composition comprises 2-20% by weight of the epoxy resin, 2-20% by weight of the curing agent, 50-90% by weight of the filler, and 0.05-5% by weight of the organosiloxane, on the basis of the total weight of the epoxy resin composition.

**6.** A semiconductor device molded by using the epoxy resin composition according to any one of claims 1 to 5.

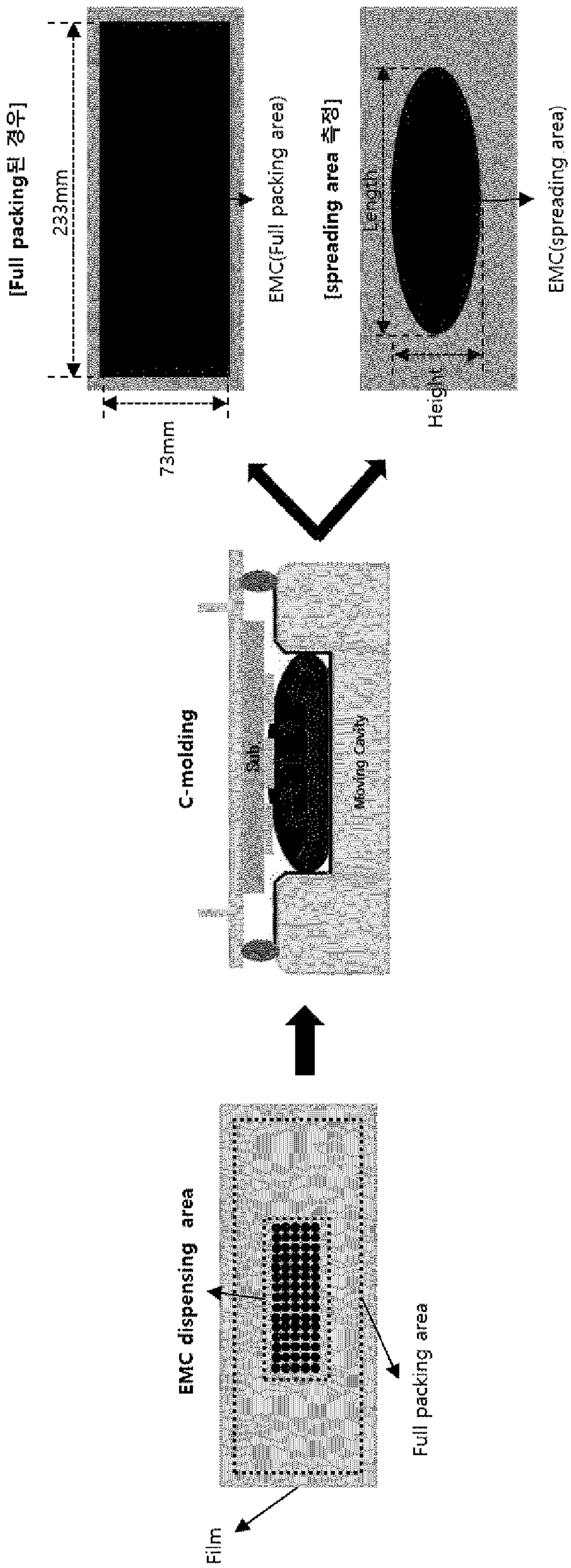
[Full packing된 경우]
233mm
73mm
EMC(Full packing area)
[spreading area 측정]
Length
Height
EMC(spreading area)
C-molding
Sub
Moving Cavity
EMC dispensing area
Full packing area
Film

FIG. 1

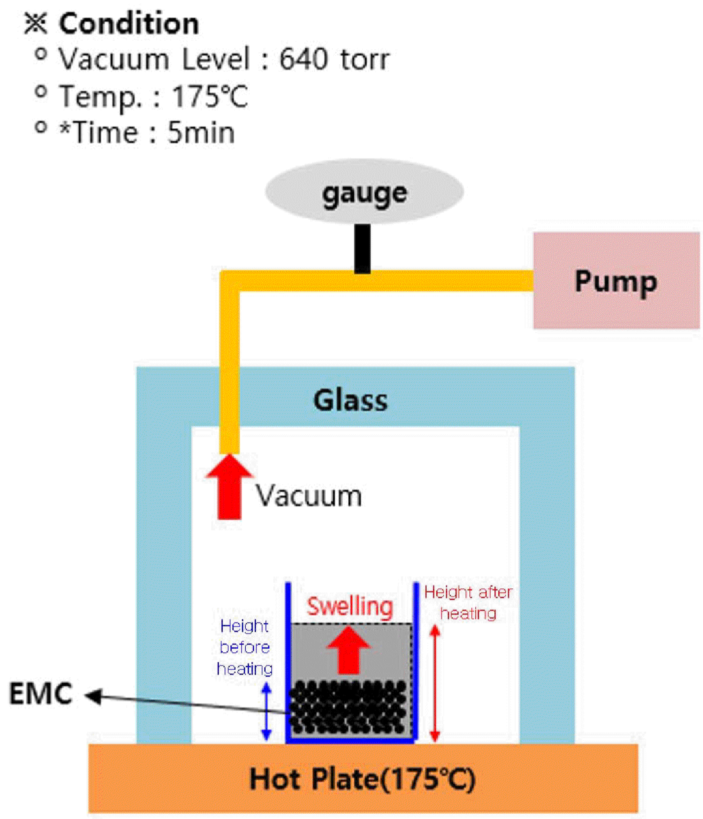
※ Condition
° Vacuum Level : 640 torr
° Temp. : 175℃
° *Time : 5min
gauge
Pump
Glass
Vacuum
Swelling
Height after heating
Height before heating
EMC
Hot Plate(175℃)

FIG. 2

## INTERNATIONAL SEARCH REPORT

International application No.
**PCT/KR2024/013209**

**A. CLASSIFICATION OF SUBJECT MATTER**

**C08K 5/5435**(2006.01)i; **C08L 63/00**(2006.01)i; **H01L 23/29**(2006.01)i

According to International Patent Classification (IPC) or to both national classification and IPC

**B. FIELDS SEARCHED**

Minimum documentation searched (classification system followed by classification symbols)

C08K 5/5435(2006.01); C08F 283/00(2006.01); C08G 59/20(2006.01); C08G 59/30(2006.01); C08G 77/46(2006.01); C08L 83/06(2006.01); C08L 83/12(2006.01); C09J 163/00(2006.01); H01L 23/29(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 밀봉(encapsulation), 반도체(semiconductor), 에폭시 수지(epoxy resin), 경화제(curing agent), 실록산(siloxane), 말단(end), 에폭시기(epoxy group)

**C. DOCUMENTS CONSIDERED TO BE RELEVANT**

| Category* | Citation of document, with indication, where appropriate, of the relevant passages | Relevant to claim No. |
|---|---|---|
| X | EP 0816461 A2 (INTERNATIONAL BUSINESS MACHINES CORPORATION) 07 January 1998 (1998-01-07)<br>See claims 1, 2, 6 and 9; page 5; and examples 1 and 9. | 1-6 |
| X | JP 2006-282988 A (SANYO CHEM. IND. LTD.) 19 October 2006 (2006-10-19)<br>See claims 1-3. | 1,6 |
| X | KR 10-2012-0139614 A (LG CHEM, LTD.) 27 December 2012 (2012-12-27)<br>See claims 1, 3-5 and 10-12. | 1,6 |
| X | CN 107567482 A (SAMSUNG SDI CO., LTD. et al.) 09 January 2018 (2018-01-09)<br>See claims 1 and 3; and chemical formulas 5-2 and 6-1. | 1 |
| A | US 5350811 A (ICHIMURA, N. et al.) 27 September 1994 (1994-09-27)<br>See claim 1; and column 4. | 1-6 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 December 2024** | **12 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/013209**

| Patent document cited in search report | Publication date (day/month/year) | Patent family member(s) | Publication date (day/month/year) |
|---|---|---|---|
| EP 0816461 A2 | 07 January 1998 | CN 1083872 C | 01 May 2002 |
| | | CN 1169452 A | 07 January 1998 |
| | | EP 0816461 A3 | 14 January 1998 |
| | | JP 10-064929 A | 06 March 1998 |
| | | JP 3349395 B2 | 25 November 2002 |
| | | KR 10-0232812 B1 | 01 December 1999 |
| | | KR 10-1998-0002194 A | 30 March 1998 |
| | | SG 50837 A1 | 20 July 1998 |
| | | TW 515833 B | 01 January 2003 |
| | | US 5700581 A | 23 December 1997 |
| JP 2006-282988 A | 19 October 2006 | None | |
| KR 10-2012-0139614 A | 27 December 2012 | CN 103608408 A | 26 February 2014 |
| | | CN 103608408 B | 13 April 2016 |
| | | EP 2722366 A2 | 23 April 2014 |
| | | EP 2722366 B1 | 04 January 2023 |
| | | JP 2014-518292 A | 28 July 2014 |
| | | JP 2015-193850 A | 05 November 2015 |
| | | JP 5831958 B2 | 16 December 2015 |
| | | JP 6066140 B2 | 25 January 2017 |
| | | US 2014-0175333 A1 | 26 June 2014 |
| | | US 9123647 B2 | 01 September 2015 |
| | | WO 2012-173460 A2 | 20 December 2012 |
| | | WO 2012-173460 A3 | 28 March 2013 |
| CN 107567482 A | 09 January 2018 | CN 107567482 B | 05 February 2021 |
| | | KR 10-1731703 B1 | 02 May 2017 |
| | | KR 10-2016-0130090 A | 10 November 2016 |
| | | US 10604652 B2 | 31 March 2020 |
| | | US 2018-0030273 A1 | 01 February 2018 |
| | | WO 2016-175509 A1 | 03 November 2016 |
| US 5350811 A | 27 September 1994 | JP 04-010442 A | 14 January 1992 |
| | | JP 04-046920 A | 17 February 1992 |
| | | JP 04-308594 A | 30 October 1992 |
| | | US 5258139 A | 02 November 1993 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017197620 A


### Non-patent literature cited in the description


- *CHEMICAL ABSTRACTS*, 1201169-35-8
- *CHEMICAL ABSTRACTS*, 0106466-55-1
- *CHEMICAL ABSTRACTS*, 0205830-20-2
- *CHEMICAL ABSTRACTS*, 0101810-98-4